# FASCICULE DE BREVET EUROPEEN

(11) **EP 0 581 639 B1**
(45) Date de publication et mention de la délivrance du brevet: **28.12.1994**
(21) Numéro de dépôt: 93401836.7
(22) Date de dépôt: 15.07.1993
(51) Int. Cl.: H02H 3/24, G11C 7/00, G11C 16/06

(54) **Dispositif de protection d'un circuit intégré contre les coupures d'alimentation**
Schutzschaltung gegen Stromunterbrechungen für eine integrierte Schaltung
Circuit for protecting integrated circuit against cuts in power supply

(30) Priorité: 31.07.1992 FR 9209566
(43) Date de publication de la demande: 02.02.1994
(73) Titulaire: SGS-THOMSON MICROELECTRONICS S.A., 94250 Gentilly (FR)
(72) Inventeur: Rouy, Olivier, F-75116 Paris (FR)
(74) Mandataire: Ballot, Paul Denis Jacques

(56) Documents cités:
- EP-A- 0 019 222
- DD-A- 264 095
- US-A- 4 096 560
- US-A- 4 975 883

## Description

La présente invention se rapporte aux dispositifs qui permettent de protéger les circuits intégrés contre les coupures intempestives de l'alimentation afin de ne pas mémoriser, ni effacer, les données de manière aléatoire. Elle s'applique plus particulièrement aux mémoires du type électriquement programmable, en particulier à celles du type électriquement effaçable.

On sait que de manière générale dans les circuits intégrés, plus particulièrement dans les mémoires, y compris les mémoires programmables, on utilise une tension d'alimentation normale, appelée conventionnellement Vcc, destinée à faire fonctionner les circuits logiques du circuit intégré. Dans le cas des mémoires programmables on utilise en outre une autre tension nettement plus élevée, de l'ordre de 20 volts par exemple, permettant justement d'obtenir cette programmation par migration de charges dans une couche d'oxyde au niveau des cellules à programmer. Cette deuxième tension, appelée couramment Vpp, est également utilisée dans le cas des mémoires programmables qui sont en outre électriquement effaçables.

On sait que, selon des valeurs courantes, la programmation de tout un plan mémoire dure environ une seconde, et son effacement environ 5 secondes. Une panne inopinée pendant ces opérations sur la première tension d'alimentation Vcc, celle qui fait fonctionner la logique de la mémoire, est susceptible d'amener des inconvénients graves lorsqu'elle se produit pendant la programmation ou l'effacement, si la deuxième tension Vpp utilisée pour cette programmation et/ou cet effacement n'est pas coupée avant que la logique ne devienne défaillante à la suite de la chute de tension progressive de la tension Vcc.

En effet, une coupure d'alimentation dans un système logique tel qu'un microprocesseur, ou même une mémoire en dehors de ces opérations de programmation et/ou d'effacement, ne nécessite généralement qu'une réinitialisation du système lorsque l'alimentation peut être rétablie. Si par contre des données erronées ont été involontairement programmées, ou des données correctes effacées partiellement, la réinitialisation ne corrigera pas ces erreurs et le système fonctionnera donc à partir de données au moins partiellement fausses. Ceci peut amener des résultats catastrophiques. On peut imaginer ainsi que, dans le cas d'une application bancaire par exemple, on crédite ou on débite des sommes importantes et ne correspondant à aucune transaction, dans la mémoire d'une carte "à puce" par exemple.

La solution retenue jusqu'à présent consiste à découpler en aval les accès aux cellules mémoires elles-mêmes, à l'aide de la logique interne à la mémoire lorsque celle-ci est actionnée sur la détection de la chute de tension Vcc, par un dispositif du type "chien de garde" par exemple. Ce système présente cependant l'inconvénient de ne pas fonctionner, justement à cause de cette chute de la tension Vcc.

Pour pallier cet inconvénient, l'invention propose un dispositif de protection d'un circuit intégré contre les coupures d'alimentation, ce circuit intégré étant destiné à être alimenté par au moins une tension d'alimentation normale Vcc et par une tension Vpp de programmation et/ou d'effacement, principalement caractérisé en ce qu'il comprend des moyens de coupure insérés en série entre la source de la tension Vpp et l'entrée d'alimentation du circuit intégré correspondant à cette source, et des moyens de commande de ces moyens de coupure reliés à la source de la tension Vcc pour commander la coupure lorsque la valeur de la tension Vcc chute au delà d'un certain seuil et avant que cette chute n'atteigne une valeur à partir de laquelle le fonctionnement logique du circuit intégré devient aléatoire.

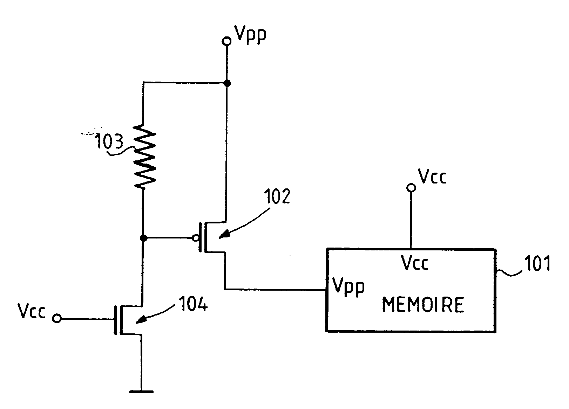

D'autres particularités et avantages de l'invention apparaîtront clairement dans la description suivante présentée à titre d'exemple non limitatif en regard de la figure unique annexée qui représente un schéma de principe d'un dispositif selon l'invention.

Dans ce schéma, le circuit intégré 101 est alimenté par la tension normale de fonctionnement Vcc. Il comprend en outre une autre entrée d'alimentation destinée à recevoir la tension de programmation et/ou d'effacement Vpp.

Selon l'invention, cette deuxième entrée d'alimentation est alimentée à partir de la source de tension d'alimentation Vpp, par l'intermédiaire d'un premier transistor MOS 102 de type P, qui est branché en série entre cette source de tension et l'entrée Vpp correspondante du circuit 101. La grille de ce transistor 102 est reliée à la source Vpp par l'intermédiaire d'une résistance de polarisation 103. Dans ces conditions ce transistor serait bloqué. Pour le débloquer on ramène à la masse la grille ainsi polarisée par la résistance 103, à l'aide d'un deuxième transistor MOS 104. Celui-ci est du type N, et il est branché en série entre la grille du transistor 102 et la masse.

Pour que ce deuxième transistor 104 soit lui-même conducteur et ramène donc la grille du transistor 102 à un potentiel bas, permettant de débloquer ce transistor 102, la grille du deuxième transistor 104 est elle-même reliée à la source de tension Vcc.

Avec ce branchement, et lorsque Vcc et Vpp ont leur valeurs nominales, le transistor 104 est conducteur et rend donc conducteur le transistor 102, ce qui permet d'alimenter le circuit intégré à partir de la source de tension Vpp.

Lorsque la tension Vcc chute, à la suite d'une panne d'alimentation par exemple, le transistor 104 se bloque, ce qui fait remonter le potentiel de la grille du transistor 102 à une valeur proche de Vpp et bloque à ce moment-là ce transistor 102, en coupant donc l'alimentation du circuit 101 par la source de tension Vpp .

Le circuit de l'invention est rapide à réagir à la montée de l'alimentation, alors que la logique ne fonctionne par exemple pas encore. Par contre, à la descente, la logique du circuit 101 assure la sécurité jusqu'à un niveau faible de Vcc. Au delà de ce niveau faible le circuit de l'invention prend le relai en coupant la transmission de Vpp. Cette coupure se produit avant que la tension Vcc n'ait chuté d'une manière trop importante, ce qui aurait entraîné un mauvais fonctionnement du circuit 101. Cette condition est facile à remplir avec les transistors MOS du type courant dans le commerce. Le dimensionnement de ceux-ci peut servir à fabriquer un circuit spécialisé pour cet usage, ou même être intégré dans les circuits internes du circuit intégré 101.

En outre, un tel montage fonctionne bien pour des tensions d'alimentation Vcc relativement basses, pouvant atteindre un ou deux volts, dont on sait qu'elles sont de plus en plus envisagées pour l'alimentation des circuits intégrés, pour des questions de durée de fonctionnement dans les appareils portables alimentés par batterie.

Il faut que la résistance 103 soit relativement forte pour que lorsque 104 est passant, le potentiel de la grille de 102 soit bas pour transmettre Vpp. Le temps de réponse de 102 est de l'ordre de la nanoseconde car il n'y a qu'à charger ou décharger les capacités drain-substrat de 104 et grille-substrat de 102. Le transistor 102 se bloque alors très vite. Le seuil de coupure est déterminé en partie par la valeur de la résistance.

## Revendications

1. Dispositif de protection d'un circuit intégré (101) contre les coupures d'alimentation, ce circuit intégré étant destiné à être alimenté par au moins une tension d'alimentation normale Vcc et par une tension Vpp de programmation et/ou d'effacement, caractérisé en ce qu'il comprend des moyens de coupure (102) insérés en série entre la source de la tension Vpp et l'entrée d'alimentation du circuit intégré correspondant à cette source, et des moyens de commande (104) de ces moyens de coupure reliés à la source de la tension Vcc pour commander la coupure lorsque la valeur de la tension Vcc chute au delà d'un certain seuil et avant que cette chute n'atteigne une valeur à partir de laquelle le fonctionnement logique du circuit intégré devient aléatoire.

2. Dispositif selon la revendication 1, caractérisé en ce qu'il comprend un premier transistor MOS (102) du type P inséré en série entre la source de la tension Vpp et l'entrée correspondante du circuit intégré (101), une résistance de polarisation (103) reliant la source de la tension Vpp à la grille de ce premier transistor, un deuxième transistor MOS (104) du type N connecté en série entre la grille du premier transistor et la masse, et des moyens de connexion de la grille de ce deuxième transistor à la source de la tension Vcc.

3. Dispositif selon l'une quelconque des revendications 1 et 2, caractérisé en ce que le circuit intégré (101) est une mémoire programmable et effaçable électriquement.

## Patentansprüche

1. Schutzvorrichtung für eine integrierte Schaltung (101) gegen Stromunterbrechungen, wobei vorgesehen ist, daß die integrierte Schaltung durch wenigstens eine normale Versorgungsspannung Vcc und durch eine Programmier- und/oder Löschspannung Vpp versorgt wird, dadurch **gekennzeichnet**, daß sie Unterbrechungsmittel (102), die in Reihe zwischen der Quelle der Spannung Vpp und dem Versorgungseingang der integrierten Schaltung entsprechend dieser Quelle zwischengeschaltet sind, und Steuermittel (104) für die Unterbrechungsmittel umfaßt, die mit der Quelle der Spannung Vcc verbunden sind und die Unterbrechung steuern, wenn der Wert der Spannung Vcc über eine bestimmte Schwelle hinaus abfällt und bevor dieser Abfall einen Wert erreicht, ab dem die logische Funktion der integrierten Schaltung zufällig wird.

2. Vorrichtung nach Anspruch 1, dadurch **gekennzeichnet**, daß sie einen ersten MOS-Transistor (102) vom P-Typ, der in Reihe zwischen der Quelle der Spannung Vpp und dem entsprechenden Eingang der integrierten Schaltung (101) zwischengeschaltet ist, einen Polarisationswiderstand (103), der die Quelle der Spannung Vpp mit der Steuerelektrode des ersten Transistors verbindet, einen zweiten MOS-Transistor (104) vom N-Typ, der in Reihe zwischen der Steuerelektrode des ersten Transistors und der Masse geschaltet ist, und Mittel zur Verbindung der Steuerelektrode des zweiten Transistors mit der Quelle der Spannung Vcc umfaßt.

3. Vorrichtung nach einem beliebigen der Ansprüche 1 und 2, dadurch **gekennzeichnet**, daß die integrierte Schaltung (101) ein programmierbarer und elektrisch löschbarer Speicher ist.

## Claims

1. Device for protecting an integrated circuit (101) against power disconnections, this integrated circuit being designed to be powered by at least one normal supply voltage total Vcc and by a programming and/or erasure voltage Vpp, characterised in that it comprises cut-off means (102) inserted in series between the voltage source Vpp and the power supply input of the integrated circuit corresponding to this source, and means (104) for controlling these cut-off means connected to the voltage source Vcc in order to demand cut-off when the value of the voltage Vcc drops below a certain threshold and before this drop reaches a value as from which the logic functioning of the integrated circuit becomes aleatory.

2. Device according to Claim 1, characterised in that it comprises a first p-type MOS transistor (102) inserted in a series between the voltage source Vpp and the corresponding input of the integrated circuit (101), a bias resistor (103) connecting the voltage source Vpp to the gate of this first transistor, a second, n-type MOS transistor (104) connected in series between the gate of the first transistor and earth, and means for connecting the gate of this second transistor to the voltage source Vcc.

3. Device according to either one of Claims 1 and 2, characterised in that the integrated circuit (101) is an electrically erasable programmable memory.
